# EUROPEAN PATENT SPECIFICATION

(11) **EP 0 404 520 B1**
(45) Date of publication and mention of the grant of the patent: **02.03.1994**
(21) Application number: 90306681.9
(22) Date of filing: 19.06.1990
(51) Int. Cl.: B65D 6/18, B65D 6/26

(54) **Collapsible container for storage and transport of manufactured articles**
Zusammenlegbarer Behälter für die Lagerung und den Transport von erzeugten Gegenständen
Récipient pliant pour l'entreposage et le transport d'articles manufacturés

(30) Priority: 19.06.1989 JP 156345/89
(43) Date of publication of application: 27.12.1990
(73) Proprietor: SONY CORPORATION, Tokyo (JP)
(72) Inventor: Hosoda, Toshikazu, Kisarazu-shi, Chiba-ken (JP); Aida, Koichiro, Shinagawa-ku, Tokyo (JP); Nakano, Tamotsu, Shinagawa-ku, Tokyo (JP)
(74) Representative: Ayers, Martyn Lewis Stanley

(56) References cited:
- EP-A- 0 015 859
- EP-A- 0 075 655
- DE-A- 3 201 068
- US-A- 1 745 317
- US-A- 4 091 919
- US-A- 4 235 345

## Description

The present invention relates generally to a container structure for storage; in particular, to a container capable of receiving printed circuit boards to allow optimal storage and transport thereof. More particularly, the invention relates to a collapsible container for facilitating storage thereof when not in use.

Usually, in processes of manufacturing, large resin and metal baskets or corrugated fiberboard boxes are used for storing or transporting. In electronics manufacturing, printed circuit boards are stored and moved in these types of containers. However, corrugated fiberboard boxes have the disadvantage of lower durability and, further, they produce undesirable paper dust with use. When used to transport printed circuit boards, this dust may interfere with the delicate functioning of electronic parts mounted on the printed boards. Large resin baskets are made of resin reinforced by metal or so forth, and thus the weight thereof is increased and manufacturing costs become high. Further, a large amount of space is necessary for the storage of such large baskets.

Collapsible containers are known, for instance and can be seen from EP-A-0,015,859 which relates to a rectangular box the ends and floor of which are folded inward when collapsed. This has a further member at the top which can be pivoted up from within the collapsed container, upon opening, and is used to hold the container in a rigid open state.

It is accordingly one object of the present invention to avoid the disadvantages of the prior art.

It is another object of the invention to provide a light container which is collapsible for storage in a small area when not in use.

According to one aspect of the present invention, there is provided a collapsible container comprising:
a pair of first plates arranged substantially parallel to each other;
a pair of second plates both connected to said both first plates, to define a storage space between both sets of said plates; and
hinge means respectively provided on said first plates, said hinge means allowing said second plates to be arranged closely proximate to each other at a first preselected distance defining a collapsed position and to be moved away from each other to an open position;
characterised by further comprising four support members movable between first and second positions, each said support member being pivotably supported, to rotate, at a first one of its ends on a respective corner of one or other of said second plates and, in said first position, engaging and retaining with the second one of its ends the opposing corner of the other second plate spaced at a second preselected distance defining said open position and, in said second position, allowing said second plates to move toward each other.

In the preferred mode, a plurality of ribs are formed on the pair of second plates to define grooves for receiving a plurality of flat members, for storage of the flat members.

The present invention will be understood from the detailed description given hereinbelow and from the accompanying drawings of the preferred embodiments which are given for explanation and understanding only and are not intended to imply limitation of the invention.

Fig. 1 is a perspective view which shows a basket for storing printed boards according to the present invention.

Fig. 2 is a plan view of Fig. 1.

Fig. 3 is a partial plan view which shows the structure of the folded basket of Fig. 1.

Fig. 4 is a side view which shows an inner wall structure of a side plate of a basket according to the invention.

Fig. 5 is an exploded view which shows an end plate of a basket.

Fig. 6 is a perspective view which shows an arrangement of supporting members.

Fig. 7 is a sectional view which shows a stack of baskets.

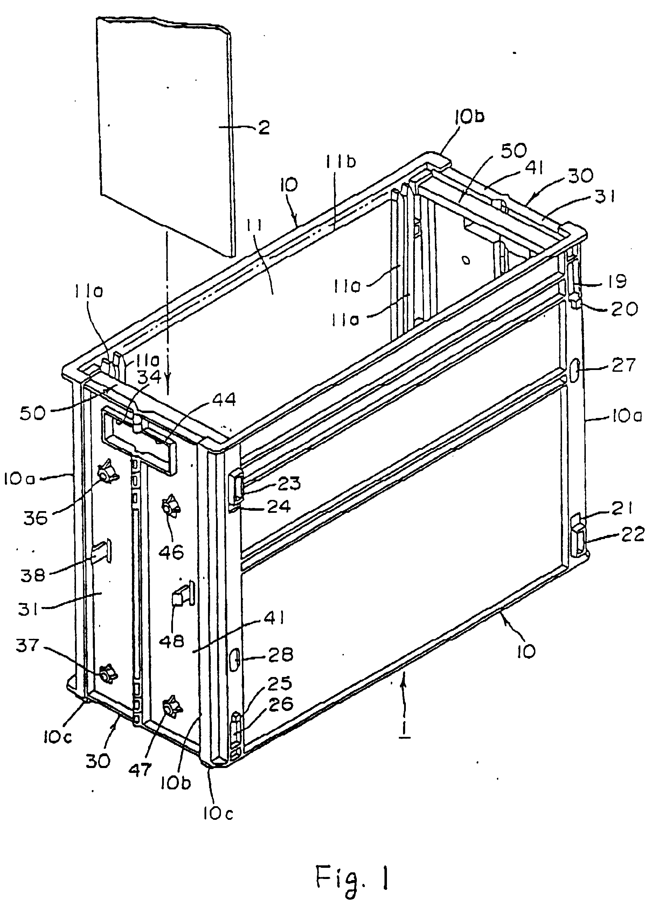

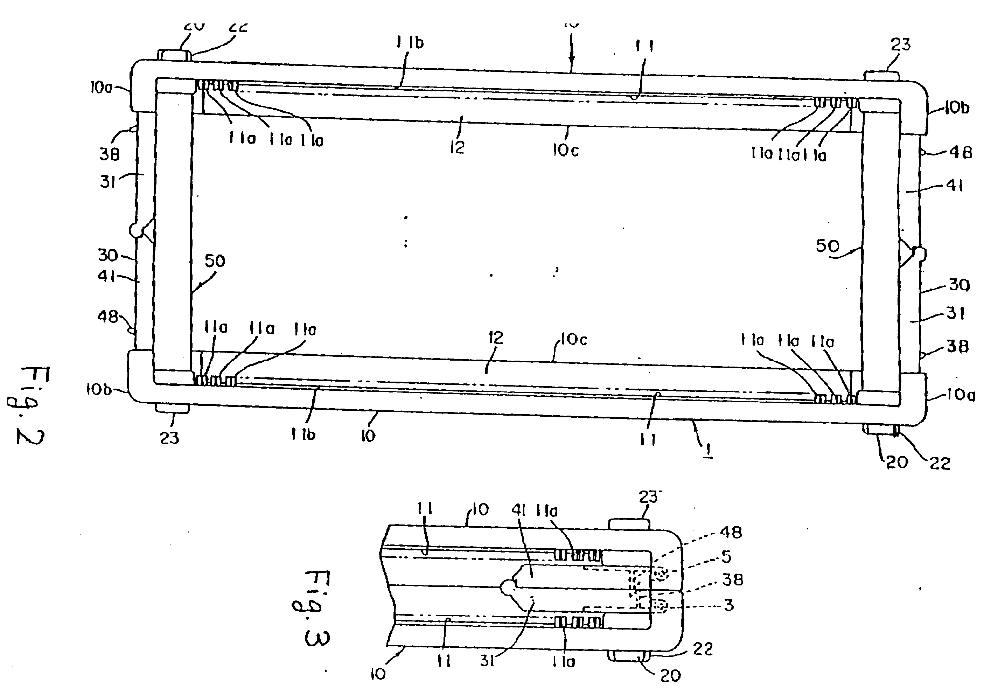

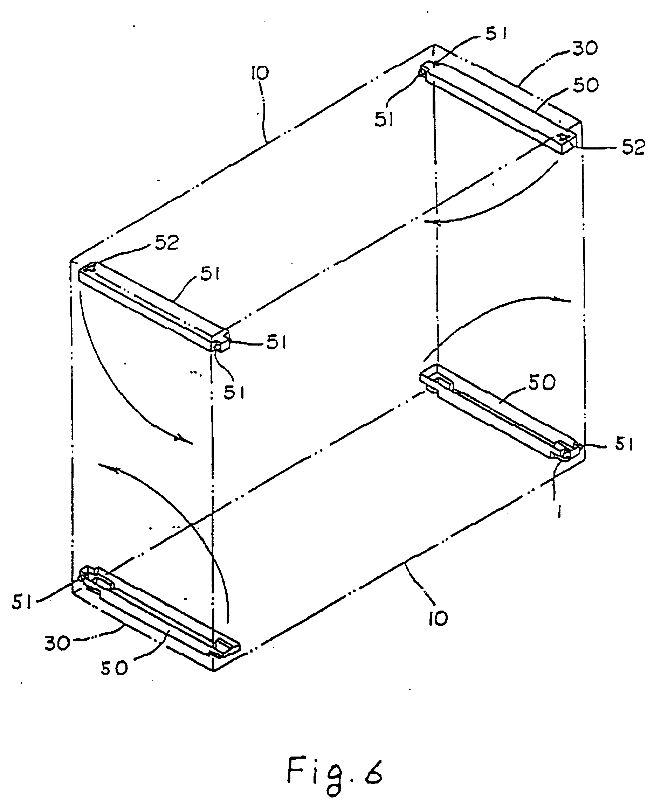

Referring now to the drawings, particularly to Figs. 1 and 2 there is illustrated a collapsible basket for storing printed boards according to the present invention. This basket 1 is made of plastic and includes generally a pair of substantially C-shaped side plates 10, a pair of hinged end plates 30, and four supporting members 50 (see Fig. 6). Each side plate 10 has a plurality of ribs 11a on its inner wall 11 which extend vertically and parallel to each other with preselected gaps to define a plurality of grooves for receiving the printed boards 2.

Each end plate 30 is foldable at its center and pivotable about corners or ends 10a and 10b of the side plates 10 so that the side plates meet or are spaced away from each other. Each supporting member 50 is pivotably supported at one of its ends by a corner of the respective side plate 10, so that it lies vertically on the inside of the corner 10a or 10b of the side plate 10 when the basket is folded up. When the basket is assembled for use, each supporting member retains the side plates 10 spaced from each other by a preselected distance, for receiving the printed boards between the ribs.

The rib 11a has tapered surfaces on its upper end for facilitating insertion of the printed board 2. An upper end 11b of the side plate 11 also has a tapered surface for the same purpose. Legs 10c are formed on lower edges of the side plates 10, each horizontally extending inwardly. Rubber strips 12 are attached on upper surfaces of the legs 10c, respectively to receive a bottom of the printed board 2 for absorbing shock caused by insertion thereof in the grooves between ribs 11a, thus protecting the edges of the board 2 from being damaged.

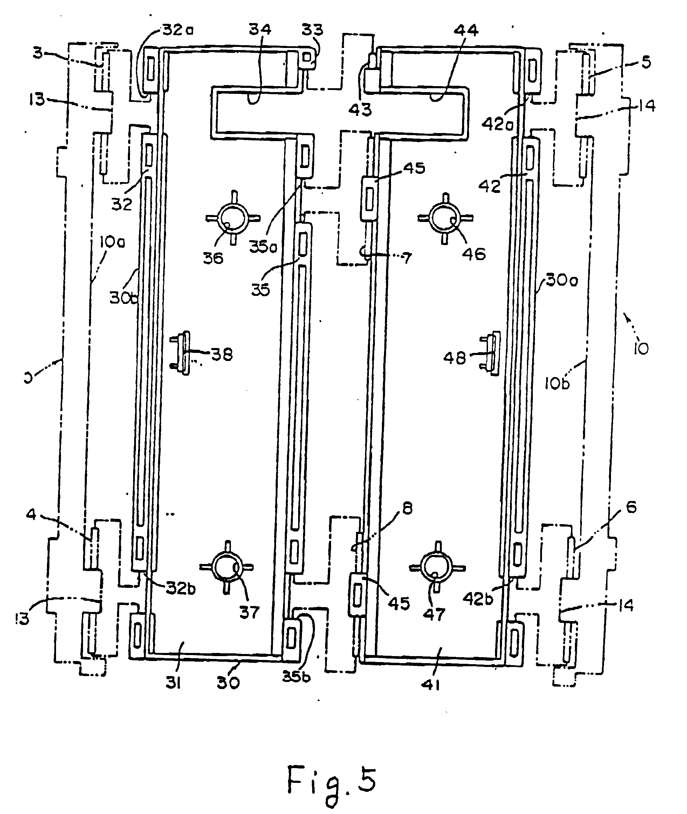

Shaft bushings 13 are, as shown in Figs. 4 and 5, integrally formed on upper and lower sides of the L-shaped corner 10a of the side plate 10. Similarly, shaft bushings 14 are formed on upper and lower sides of the other corner 10b. They define a hinge in cooperation with shaft bushings provided on the end plates 30 as will be described hereinafter.

A hook 15 and bearing 16 are formed between the shaft bushings 13 and the outmost rib 11a on the upper and lower sides of the inner wall 11. The hook 15 engages one end of the supporting member 50 when the basket is assembled. The bearing 16 pivotaly supports the other end of the supporting member. Similarly, on the other side of the inner wall 11, a hook 18 and bearing 17 are formed.

Referring to Fig. 1 again, a rectangular recessed portion 19 and a square protrusion 20 are formed on the upper outside of the corner 10a and a square recessed portion 21 and a hollow rectangular protrusion 22 are formed on the lower outside corner. On the corner 10b, a rectangular protrusion 23 and a square recessed portion 24 are formed on the upper side and a square protrusion 25 and a rectangular recessed portion 26 are formed on the lower side, in an arrangement complementary to the corner 10a. When a plurality of baskets are placed on their sides, the protrusions fit into the recessed portions of adjacent baskets, positioning them securely.

Openings 27 and 28 are provided in the corners 10a and 10b for releasing an end of the supporting members 50 from a locked position of the basket when assembling. Inside both of the openings 27 and 28, as shown in Fig. 4, pairs of protrusions 27a and 28b are formed to retain the supporting member vertically on the inside of the corners 10a and 10b when collapsed.

Referring to Fig. 5, the end plate 30 is shown. This end plate is provided with a pair of rectangular plastic plates 31 and 41 which are folded on hinges. The plate 31 has a cylindrical shaft bushing 32 on one side 30b connected to the side plate 10 at upper and lower portions at which cut-out portions 32a and 32b are formed for receiving the shaft bushings 13 provided on the corners of the side plate 10. Plastic shafts 3 and 4 are inserted thereinto to complete the hinge structure. Similarly, the plate 41 has a cylindrical shaft bushing 42 in upper and lower sides in which cut-out portions 42a and 42b are formed to be rotatably supported by the other side plate 10 by insertion of plastic pins 5 and 6 thereinto.

On the other side of the plate 31 are provided a shaft bushing 33, a cut-out portion 34, and a long shaft bushing 35 having cut-out portions 35a and 35b formed in upper and lower portions thereof. On the other side of the plate 41 are provided a pin 43 inserted into the shaft bushing 33 of the plate 31, a cut-out portion 44 for defining an opening in conjunction with the cut-out portion 34 as a handle for when the basket is carried, and a pair of shaft bushings 45 inserted into the cut-out portions 35a and 35b of the plate 31.

By inserting shafts 7 and 8 through the shaft bushings of the plates 31 and 41, this hinge structure is completed. Hollow bosses 36, 37, 46, and 47 are provided on the outer wall of the plates 31 and 41 for positioning the basket, during automatic transfer by conveyer, for example. Hooks 38 and 48 are provided on the middle portion of the outer wall for engaging with each other when the end plates are folded to hold them closed.

Fig. 6 shows the supporting members 50. Each supporting member 50 is substantially in the form of a square bar, and includes a pair of pins 51 on one end which are pivotably supported by the bearings 16 or 17 of the side plate 10 and a hole 52 on the other end, the free end, which is engaged with the hook 15 or 18. It is seen that the supporting members 50 at the top of the basket swing downwardly in the direction indicated by the upper arrows in Fig. 6, to be positioned vertically when the basket is folded. Conversely, the supporting members 50 at the top of the basket swing upwardly to be positioned horizontally, holding the side plates 10 suitably spaced from each other, when the basket is assembled.

With the above-mentioned basket structure, when the basket 1 is to be used, pulling the side plates 10 away from each other causes the end plates 30 to open to 180°. Pushing the portion of the supporting members 50 visible through the openings 27 and 28, releases the retained ends of the supporting members to allow them to swing 90°, so that the openings formed in the ends thereof may be engaged with the hooks 15 or 18. Thereby, the basket 1, as shown in Fig. 1, may be assembled easily. The pushing of the supporting members through the openings 27 and 28 may be carried out manually. Alternatively, it may be carried out automatically utilizing instruments (not shown).

When a printed board 2 is inserted into the grooves between ribs 10a, the lower edge thereof contacts the rubber strip 12 attached on the legs 10c to absorb shock at that time, thereby preventing the printed board from being damaged. The bottom of the basket has an opening end, by pushing the lower edge of the stored printed board upward therethrough, it can be easily removed from the top of the basket.

In addition, when the basket 1 is transferred by a carrier machine, for example, positioning the basket 1 on the machine may be accomplished easily and precisely by using the hollow bosses 36, 37, 46, 47.

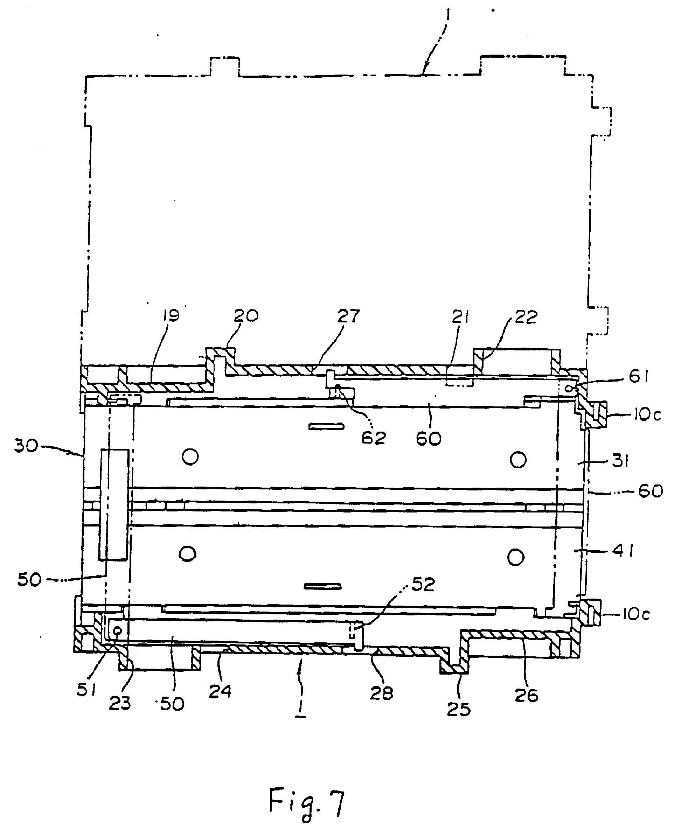

Referring to Fig. 7, a row of baskets 1 is illustrated. The recessed portions 19 and 26 and the protrusions 22 and 23 of one side of a first basket respectively engage the protrusions 23 and 22 and the recessed portions 26 and 19 of the facing side of the adjacent basket, thereby preventing the baskets from shifting and/or tumbling easily. Alternatively, when the baskets are stacked vertically, the legs 10c of an upper basket fit securely onto a ledge formed by a top surface of the supporting members 50, retained by the higher edge of the inner wall of the plate 31, allowing secure stacking of the baskets without shifting. Therefore, many printed boards 2 can be stored and safely transported in uniform baskets.

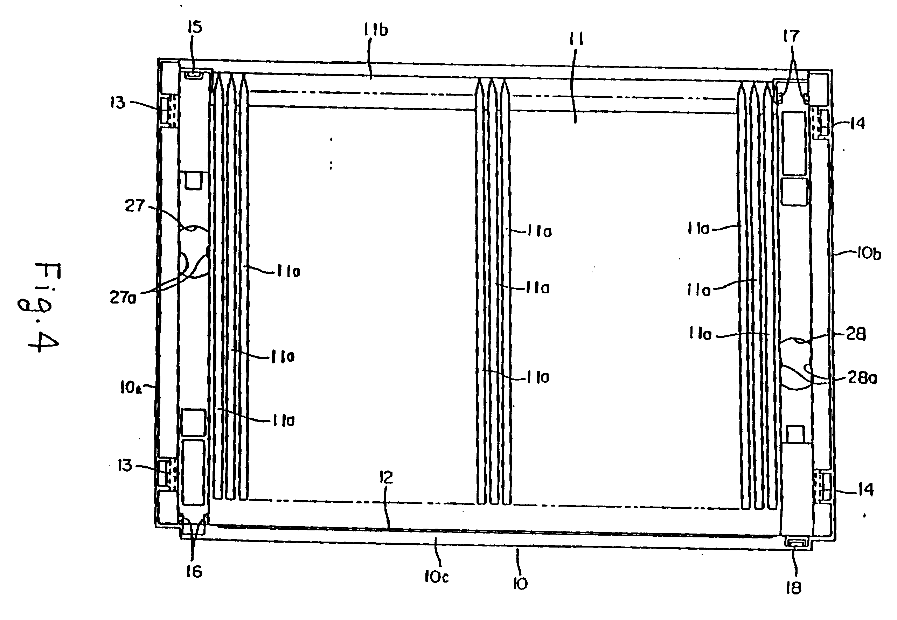

When the baskets are not in use, as shown in Fig. 6, the supporting members 50 fold into the inner wall of the side plate to a vertical position, and the end plates 30 fold inwardly to join the side plate 10, the inner edges of the legs 10c thereof contacting each other. The hooks 38 and 48 of the end plate, as shown in Fig. 3, then engage each other, preventing the basket from opening accidentally. The folded basket has a thickness of less than one-third that of the opened basket, thus reducing the area necessary for storage.

While the present invention has been disclosed in terms of the preferred embodiment in order to facilitate better understanding thereof, it should be appreciated that the invention can be embodied in various ways without departing from the principles thereof. Therefore, the invention should be understood to include all possible embodiments and modifications to illustrated embodiments which can be embodied without departing from the principle of the invention as set out in the appended claims. For example, substrates may be stored in the basket in place of printed boards. Further, by providing adjustments for varying length of the supporting members or the angle of the opened end plates, printed boards having different sizes can be stored in the basket.

## Claims

1. A collapsible container comprising:
a pair of first plates (30) arranged substantially parallel to each other;
a pair of second plates (10) both connected to said both first plates, to define a storage space between both sets of said plates (10, 30); and
hinge means respectively provided on said first plates (30), said hinge means allowing said second plates (10) to be arranged closely proximate to each other at a first preselected distance defining a collapsed position and to be moved away from each other to an open position;
characterised by further comprising four support members (50) movable between first and second positions, each said support member (50) being pivotably supported, to rotate, at a first one of its ends on a respective corner of one or other of said second plates (10) and, in said first position, engaging and retaining with the second one of its ends the opposing corner of the other second plate spaced at a second preselected distance defining said open position and, in said second position, allowing said second plates (10) to move toward each other.

2. A collapsible container as set forth in claim 1, wherein a plurality of ribs (lla) are formed on each of said pair of second plates (10), to define grooves for receiving a plurality of flat members (2) for storage of said flat members (2).

3. A collapsible container as set forth in claim 2, further comprising an elastically deformable member (12) which is disposed on a lower portion of each said second plate (10) for absorbing shock caused by insertion of a flat member (2) into the container to prevent a lower edge of said flat member (2) from being damaged.

4. A collapsible container as set forth in claim 1, 2 or 3, wherein each said second plate (10) includes lock means (27a, 28b) for locking said second end of each respective one of said support members (50), when said support member (50) is retained on said second plate (10) while said second plates (10) are in said collapsed position.

5. A collapsible container as set forth in claim 4, wherein each said second plate (10) includes an opening (27, 28) allowing access to said second end of a respective one of said support members (50), when said second end is locked by said lock means (27a, 28b), from outside of the container to release said locked second end.

6. A collapsible container as set forth in any one of the preceding claims, wherein said first plates (30) include first and second segments (31, 41) which can swing inward on said hinge means, wherein said first and second segments (31, 41) fold towards each other.

7. A collapsible container as set forth in claim 6, wherein said first and second segments (31, 41) have hooks (38, 48) for respective engagement with each other when said first plates (30) are fully folded.

8. A collapsible container as set forth in any one of claims 1 to 7, wherein said second plate (10) has engaging means which includes a recessed portion (19, 21, 24, 26) and a protrusion (20, 22, 23, 25) for preventing adjacent containers from shifting relative to each other when a plurality of the containers are arranged adjacent to each other with respective recessed portions (19, 21, 24, 26) and protrusions (20, 22, 23, 25) engaged.

9. A collapsible container as set forth in any one of the preceding claims, wherein said second plates (10) further include protrusions (10c) on a lower surface thereof, respective pairs of said protrusions (10c) corresponding to a ledge defined by the length of said respective one of said support members (50) such that one container may be securely stacked upon another.

10. A collapsible container as set forth in claim 9, wherein said second end of each said support member (50) is connected to the respective one of said second plates (10) by a hook means (15, 18).

11. A collapsible container as set forth in any one of the preceding claims, wherein hinge means are flexible.

## Patentansprüche

1. Zusammenlegbarer Behälter, der aufweist:
zwei erste Platten (30), die im wesentlichen parallel zueinander angeordnet sind;
zwei zweite Platten (10), die mit den beiden ersten Platten verbunden sind, um einen Lagerraum zwischen beiden Plattensätzen (10, 30) zu bilden; und
Scharniermittel, die jeweils auf den ersten Platten (30) vorgesehen sind, wobei die Scharniermittel es den zweiten Platten (10) erlauben, daß sie in enger Nähe zueinander in einem ersten vorher ausgewählten Abstand angeordnet sind, durch den eine zusammengelegte Lage bestimmt wird, und daß sie voneinander weg in eine offene Lage bewegbar sind;
dadurch gekennzeichnet,
daß er vier Stützelemente (50) aufweist, die zwischen einer ersten und einer zweiten Lage bewegbar sind, wobei jedes Stützelement (50) so drehbar gelagert ist, daß es an einem ersten seiner Enden auf einer entsprechenden Ecke der einen oder einer anderen der zweiten Platte (10) drehbar ist, und,
daß sie in der ersten Lage mit dem zweiten ihrer Enden in die gegenüberliegende Ecke der anderen zweiten Platte eingreifen und diese halten, die in einem vorher ausgewählten Abstand davon beabstandet sind, durch den die offene Lage bestimmt wird, und,
daß sie in der zweiten Lage es den zweiten Platten (10) erlauben, daß sie aufeinander zu bewegbar sind.

2. Zusammenlegbarer Behälter nach Anspruch 1, wobei mehrere Rippen (lla) auf jeder der beiden zweiten Platten (10) gebildet sind, um Nuten zur Aufnahme mehrerer Flachbaugruppen (2) zum Aufbewahren der Flachbaugruppen (2) zu bestimmen.

3. Zusammenlegbarer Behälter nach Anspruch 2, der weiter ein elastisch verformbares Teil (12) aufweist, das auf einem unteren Bereich der zweiten Platte (10) angeordnet ist, um einen Stoß aufzunehmen, der durch Einfügen einer Flachbaugruppe (2) in den Behälter verursacht wird, um zu vermeiden, daß ein unterer Rand der Flachbaugruppe (2) beschädigt wird.

4. Zusammenlegbarer Behälter nach Anspruch 1, 2 oder 3, wobei jede zweite Platte (10) Verriegelungsmittel (27a, 28a) aufweist, um das zweite Ende eines entsprechenden der Stützelemente (50) zu verriegeln, wenn das Stützelement (50) auf der zweiten Platte (10) gehalten wird, während die zweiten Platten (10) in der zusammengelegten Lage sind.

5. Zusammenlegbarer Behälter nach Anspruch 4, wobei jede zweite Platte (10) eine Öffnung (27, 28) aufweist, die einen Zugriff zum zweiten Ende eines entsprechenden der Stützelemente (50) von einer Außenseite des Behälters aus erlaubt, wenn das zweite Ende durch die Verriegelungsmittel (27a, 28a) verriegelt ist, um das zweite verriegelte Ende zu lösen.

6. Zusammenlegbarer Behälter nach einem der vorhergehenden Ansprüche, wobei die ersten Platten (30) erste und zweite Teile (31, 41) aufweisen, die auf den Scharniermitteln nach innen drehen können, wobei die ersten und zweiten Teile (31, 41) zusammenklappbar sind.

7. Zusammenlegbarer Behälter nach Anspruch 6, wobei die ersten und zweiten Teile (31, 41) Haken (38, 48) aufweisen, die jeweils ineinander eingreifen, wenn die ersten Platten (30) völlig umgeklappt sind.

8. Zusammenlegbarer Behälter nach einem der Ansprüche 1 bis 7, wobei die zweite Platte (10) Koppelmittel aufweist, die einen vertieften Bereich (19, 21, 24, 26) und einen Vorsprung (20, 22, 23, 25) aufweisen, um zu verhindern, daß benachbarte Behälter sich zueinander verschieben, wenn mehrere Behälter benachbart zueinander angeordnet sind, wobei jeweils vertiefte Bereiche (19, 21, 24, 26) und Vorsprünge (20, 22, 23, 25) ineinander eingreifen.

9. Zusammenlegbarer Behälter nach einem der vorhergehenden Ansprüche, wobei die zweiten Platten (10) weiter Vorsprünge (10c) auf ihrer unteren Oberfläche aufweisen, wobei entsprechende Paare der Vorsprünge (10c) einem Absatz entsprechen, der durch die Länge des entsprechenden einen der Stützelemente (50) bestimmt ist, so daß ein Behälter sicher auf einem anderen gestapelt werden kann.

10. Zusammenlegbarer Behälter nach Anspruch 9, wobei das zweite Ende jedes Stützelements (50) mit dem entsprechenden der zweiten Platten (10) durch Scharniermittel (15, 18) verbunden ist.

11. Zusammenlegbarer Behälter nach einem der vorhergehenden Ansprüche, wobei die Scharniermittel flexibel sind.

## Revendications

1. Conteneur repliable comprenant :
une paire de premières plaques (30) disposées sensiblement parallèlement entre elles ;
une paire de deuxième plaques (10) toutes deux réunies aux deux premières plaques, pour definir un espace de rangement entre les deux jeux desdites plaques (10, 30) ; et
des moyens formant charnière respectivement prévus sur lesdites premières plaques (30), lesdits moyens formant charnière permettant auxdites deuxièmes plaques (10) de se placer très près l'une de l'autre à une première distance présélectionnée, en définissant une position repliée, et de s'écarter l'une de l'autre, dans une position ouverte ;
caractérisé en ce qu'il comprend en outre quatre éléments supports (50) qui peuvent se déplacer entre lesdites première et deuxième positions, chaque élément support (50) étant monté pivotant pour pouvoir tourner, à une première de ses extrémités, sur un angle respectif d'une ou de l'autre desdites deuxièmes plaques (10) et, dans ladite première position, attaquant et retenant avec la deuxième de ses extrémités l'angle opposé de l'autre deuxième plaque espacée d'une deuxième distance présélectionnée qui définit ladite position ouverte, tandis que, dans ladite deuxième position, il permet aux deuxièmes plaques (10) de se rapprocher l'une de l'autre.

2. Conteneur repliable selon la revendication 1, dans lequel une pluralité de nervures (11a) sont formées sur chacune des plaques de ladite paire de deuxièmes plaques (10) pour définir des rainures destinées à recevoir une pluralité d'éléments plats (2) pour le rangement desdits éléments plats (2).

3. Conteneur repliable selon la revendication 2, comprenant en outre un élément élastiquement déformable (12) qui est disposé sur une portion inférieure de chacune desdites deuxièmes plaques (10), pour absorber le choc provoqué par l'insertion d'un élément plat (2) dans le conteneur pour éviter la détérioration du bord inférieur de l'élément plat (2).

4. Conteneur repliable selon la revendication 1, 2 ou 3, dans lequel chacune desdites deuxièmes plaques (10) comprend des moyens de verrouillage (27a, 28b) servant à verrouiller ladite deuxième extrémité de chaque élément support (50) qui lui correspond respectivement lorsque ledit élément support (50) est retenu sur ladite deuxième plaque (10) pendant que lesdites deuxièmes plaques (10) sont dans ladite position repliée.

5. Conteneur repliable selon la revendication 4, dans lequel chacune desdites deuxièmes plaques (10) présente une ouverture (27, 28) qui permet d'accéder de l'extérieur du conteneur à ladite deuxième extrémité d'un desdits éléments supports (50) qui lui correspond respectivement, lorsque ladite deuxième extrémité est verrouillée par lesdits moyens de verrouillage (27a, 28b) pour libérer ladite deuxième extrémité verrouillée.

6. Conteneur repliable selon une quelconque des revendications précédentes, dans lequel lesdites premières plaques (30) comprennent des premier et deuxième segments (31, 41) qui peuvent pivoter vers l'intérieur sur lesdits moyens formant charnière, dans lequel lesdits premier et deuxième segments (31, 41) se replient l'un vers l'autre.

7. Conteneur repliable selon la revendication 6, dans lequel lesdits premier et deuxième segments (31, 41) présentent des crochets (38, 48) destinés à entrer en prise respectivement l'un avec l'autre lorsque lesdites premières plaques (30) sont entièrement repliées.

8. Conteneur repliable selon une quelconque des revendications 1 à 7, dans lequel ladite deuxième plaque (10) possède des moyens de prise qui comprennent une portion déprimée (19, 21, 24, 26) et une saillie (20, 22, 23, 25) pour empêcher les conteneurs adjacents de se déporter l'un par rapport à l'autre lorsqu'une pluralité de conteneurs sont disposés adjacents les uns aux autres avec les portions déprimées (19, 21, 24, 26) et les saillies (20, 22, 23, 25) respectives en prise.

9. Conteneur repliable selon une quelconque des revendications précédentes, dans lequel lesdites deuxièmes plaques (10) comprennent en outre des saillies (10c) sur leur surface inférieure, les paires respectives desdites saillies (10c) correspondant à un rebord défini par la longueur de celui desdits éléments supports (50) qui lui correspond respectivement, de telle manière qu'un conteneur puisse être empilé sur un autre d'une façon sûre.

10. Conteneur repliable selon la revendication 9, dans lequel ladite deuxième extrémité de chacun desdits éléments supports (50) est connectée à celle desdites deuxièmes plaques (10) qui lui correspond respectivement par un moyen du type crochet (15, 18).

11. Conteneur repliable selon une quelconque des revendications précédentes, dans lequel lesdits moyens formant charnière sont flexibles.
